# EUROPEAN PATENT SPECIFICATION

(11) **EP 4 191 636 B1**
(45) Date of publication and mention of the grant of the patent: **08.01.2025**
(21) Application number: 21858189.0
(22) Date of filing: 05.08.2021
(51) Int. Cl.: H01J 1/24, H01J 37/065

(54) **ELECTRON EMITTER**
ELEKTRONENEMITTER
ÉMETTEUR D'ÉLECTRONS

(30) Priority: 17.08.2020 JP 2020137423
(43) Date of publication of application: 07.06.2023
(73) Proprietor: Denka Company Limited, Tokyo 103-8338 (JP)
(72) Inventor: ISHIKAWA, Daisuke, Tokyo 103-8338 (JP); CHATANI, Hiromitsu, Tokyo 103-8338 (JP)
(74) Representative: Hoffmann Eitle
(86) International application number: PCT/JP2021/029180
(87) International publication number: WO 2022/039042

(56) References cited:
- JP-A- 2009 295 736
- JP-A- 2017 201 609
- JP-A- S5 451 473
- US-A1- 2010 301 736

## Description

### Technical Field

The present disclosure relates to an emitter emitting electrons and a device provided with the same.

### Background Art

An emitter emitting electrons is used in, for example, an electron microscope or semiconductor inspection equipment. The emitter includes an electron source and a heater heating the electron source to a temperature at which the electron source emits electrons. Patent Literature 1 discloses an electron source in which an electron emission material (chip) made of a hexaboride of a rare earth element is sandwiched between a pair of heating elements and the heating elements are sandwiched between a pair of conductive posts. In this electron source, an insulating coating is formed in the region of the heating element that is not in contact with the electron emission material and the conductive post. Patent Literature 2 relates to an electron gun comprising a first refractory metal, a second refractory metal, and a boron substrate. Patent Literature 3 relates to an electron emitting source in which an electrically conductive substance is provided between a tip of the electron emitting source and a heater.

### Citation List

### Patent Literature

Patent Literature 1: Japanese Unexamined Patent Publication No. 2006-12496
Patent Literature 2: Japanese Unexamined Patent Publication No. 2017-201609
Patent Literature 3: US Unexamined Patent Publication No. 2010/301736

### Summary of Invention

### Technical Problem

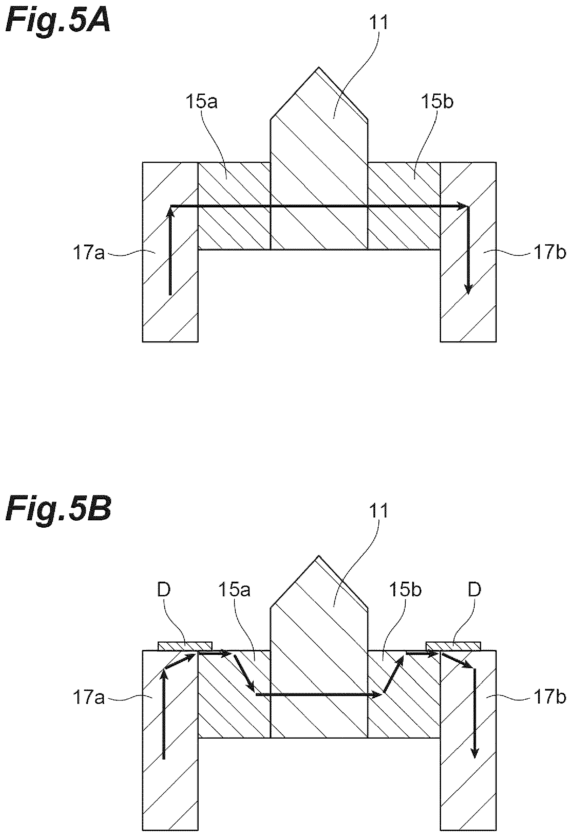

Chip observation after actual long-term operation of the electron source disclosed in Patent Literature 1 led to hexaboride deposition recognition in the vicinity of the contact of the heater with the conductive post. It is presumed that the hexaboride evaporated from the chip cannot be re-evaporated and is deposited in this region because the temperature in the vicinity of the portion of contact of the heater with the conductive post decreases due to heat conduction to the conductive post (see FIG. 5B). FIG. 5B is a longitudinal sectional view schematically illustrating a state where the material configuring an electron source 11 is deposited in the vicinity of heaters 15a and 15b. A deposit D adheres so as to partially cover the upper surfaces of conductive posts 17a and 17b and, continuously therewith, the upper surfaces of the heaters 15a and 15b. The arrows in FIGS. 5A and 5B represent a current at a time of energization. In a state where the deposit D does not adhere, electricity stably flows through the heaters 15a and 15b as illustrated in FIG. 5A. In contrast, when the deposit D adheres as illustrated in FIG. 5B, the deposit D hinders the stable flow of electricity through the heaters 15a and 15b. It should be noted that in the invention described in Patent Literature 1, a decline in reliability attributable to hexaboride deposition is suppressed by forming the insulating coating on a predetermined region of the heating element.

Provided according to the present disclosure are an emitter capable of maintaining high reliability even during long-term operation and a device provided with the same.

### Solution to Problem

One aspect of the present disclosure provides an emitter. This emitter includes: first and second heaters generating heat by energization; an electron source comprising a first material emitting an electron by being heated by the first and second heaters; and an intermediate member interposed between the electron source, and the first and second heaters, the intermediate member comprising a second material lower in thermal conductivity than the first material. The first material is a rare earth boride or a precious metal-rare earth alloy, and the second material is glassy carbon. A length of a shortest path of the intermediate member passing from the heater to the electron source is 100 µm or more.

In the emitter according to the present disclosure, the intermediate member (second material) lower in thermal conductivity than the electron source (first material) is provided between the electron source and the heater. With such a configuration, the heater can be operated at a higher temperature than in a case where the intermediate member is not provided. As a result, deposition itself of the material configuring the electron source in the vicinity of the heater can be suppressed, and a decline in emitter performance attributable thereto can be suppressed. Accordingly, the emitter according to the present disclosure is capable of stably operating for a long period of time. The thermal conductivity of the intermediate member is preferably 100 W/m·K or less. In the present disclosure, thermal conductivity means a value at 20°C measured in accordance with the method described in JIS R1611.

The emitter according to the present disclosure is based on the concept of hindering efficient heating of the electron source by the heater to some extent while using excess heat from the heater to suppress deposition of the material configuring the electron source in the vicinity of the heater (for example, a pair of conductive posts sandwiching the heater). In order to effectively realize this, it is preferable that the intermediate member is disposed between the electron source and the heater with a certain amount of volume. In other words, according to the invention the length of the shortest path of the intermediate member passing from the heater to the electron source is 100 µm or more.

The electrical resistivity of the intermediate member is preferably sufficiently smaller than the electrical resistivity of the heater. The electrical resistivity of the intermediate member is preferably 300 µΩ·m or less. By this value being 300 µΩ·m or less, excessive heat generation of the intermediate member attributable to energization can be suppressed. The electrical resistivity of the heater is preferably 500 µΩ·m or more. By this value being 500 µΩ·m or more, the heater is capable of generating sufficient heat by energization. In the present disclosure, electrical resistivity means a value at 20°C measured in accordance with the method described in JIS R7222.

The intermediate member preferably covers the surface of the electron source other than the electron emission surface thereof. By the surface of the electron source other than the electron emission surface being covered with the intermediate member, evaporated matter of the electron source at a time of energization can be trapped by the intermediate member. In other words, it is possible to suppress diffusion of at least the evaporated matter of the material of the electron source in the direction of the heater. Accordingly, a decline in emitter performance attributable to deposition of the material configuring the electron source can be suppressed to a greater extent.

One aspect of the present disclosure provides a device provided with the emitter described above. The emitter is provided in, for example, an electron microscope, semiconductor manufacturing equipment, inspection equipment, or processing equipment.

### Advantageous Effects of Invention

Provided according to the present disclosure are an emitter capable of maintaining high reliability even during long-term operation and a device provided with the same.

### Brief Description of Drawings

FIG. 1A is a longitudinal sectional view schematically illustrating a first embodiment of an emitter according to the present disclosure, and FIG. 1B is a transverse sectional view of the emitter illustrated in FIG. 1A.
FIG. 2A is a longitudinal sectional view schematically illustrating a second embodiment of the emitter according to the present disclosure, and FIG. 2B is a transverse sectional view of the emitter illustrated in FIG. 2A.
FIG. 3A is a longitudinal sectional view schematically illustrating a third embodiment of the emitter according to the present disclosure, and FIG. 3B is a top view of the emitter illustrated in FIG. 3A.
FIG. 4 is a thermographic camera image showing the upper surface temperature of an emitter according to an example.
FIG. 5A is a longitudinal sectional view schematically illustrating an emitter according to a comparative example, and FIG. 5B is a longitudinal sectional view schematically illustrating a state where a material (lanthanum boride) configuring an electron source is deposited in the vicinity of the heater of the emitter illustrated in FIG. 5A.

### Description of Embodiments

Hereinafter, embodiments of the present disclosure will be described with reference to the drawings. In the following description, the same reference numerals will be used for the same or functionally identical elements with redundant description omitted. It should be noted that the present invention is not limited to the following embodiments.

### <First Embodiment>

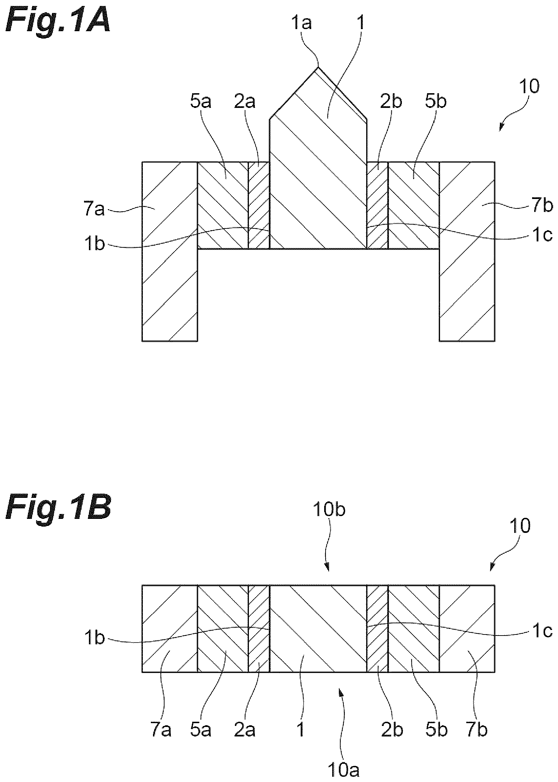

FIG. 1A is a longitudinal sectional view schematically illustrating an emitter according to a first embodiment, and FIG. 1B is a transverse sectional view of the emitter illustrated in FIG. 1A. An emitter 10 illustrated in these drawings includes an electron source 1, a pair of heaters 5a and 5b (first and second heaters) generating heat by energization, intermediate members 2a and 2b disposed between the electron source 1 and the heaters 5a and 5b, and a pair of conductive posts 7a and 7b disposed so as to sandwich these configurations. The electron source 1 is made of a material (first material) emitting electrons by being heated. The intermediate members 2a and 2b are made of a material (second material) lower in thermal conductivity than the material configuring the electron source 1. The heaters 5a and 5b are for heating the electron source 1. The pair of conductive posts 7a and 7b are for holding the electron source 1 and so on and energizing the heaters 5a and 5b. The emitter 10 is provided in, for example, an electron microscope, semiconductor manufacturing equipment, inspection equipment, or processing equipment. Each configuration of the emitter 10 will be described below.

### (Electron Source)

The electron source 1 is made of the first material (electron emission material) having electron emission properties. A tip portion 1a of the electron source 1 is molded in a conical shape, and electrons are emitted from this tip portion 1a. In the present embodiment, the electron source 1 is exposed to each of side surfaces 10a and 10b of the emitter 10.

In the present embodiment, the part of the electron source 1 other than the tip portion 1a has a quadrangular prism shape (see FIGS. 1A and 1B). The length of the electron source 1 is, for example, 0.1 to 2 mm, and the length may be 0.2 to 1.5 mm or 0.2 to 1 mm. By the length being 0.1 mm or more, handling tends to be satisfactory. By the length being 2 mm or less, heating tends to be uniform. The quadrangular prism part of the electron source 1 has a substantially square sectional shape. The length of the side is, for example, 0.02 to 1 mm, and the length may be 0.05 to 0.5 mm or 0.05 to 0.15 mm.

The material of the electron emission material includes rare earth borides such as lanthanum boride (LaB₆) and cerium boride (CeB₆); and precious metal-rare earth alloys such as iridium cerium.

From the viewpoint of electron emission properties, strength, and workability, the electron emission material configuring the electron source 1 is preferably a rare earth boride. In a case where the electron source 1 is made of a rare earth boride, the electron source 1 is preferably a single crystal processed such that the <100> orientation of easy electron emission matches the electron emission direction. The electron source 1 can be given a desired shape by, for example, electric discharge machining. The side surface of the electron source 1 is preferably a (100) crystal plane because the evaporation rate is considered to be slow.

The material configuring the electron source 1 is higher in thermal conductivity than the material configuring the intermediate members 2a and 2b. The thermal conductivity of the material configuring the electron source 1 is preferably 5 W/m·K or more, more preferably 10 W/m·K or more. By the thermal conductivity of this material being 5 W/m·K or more, the entire electron source 1 tends to be sufficiently uniformly heated by heat from the heaters 5a and 5b. It should be noted that the upper limit value of the thermal conductivity of this material is, for example, 200 W/m·K. The thermal conductivities of a plurality of materials are as follows.
·Lanthanum boride (LaB₆): 60 W/m·K
·Tungsten: 177 W/m·K

A thermal conductivity value T_{E} of the electron source 1 is preferably sufficiently larger than a thermal conductivity value T_{I} of the intermediate members 2a and 2b. The ratio (T_{E}/T_{I}) of the thermal conductivity value T_{E} of the electron source 1 to the thermal conductivity value T_{I} of the intermediate members 2a and 2b is, for example, 7 to 13, and the ratio may be 8 to 12 or 10 to 11. By this ratio being within these ranges, the temperature of the heaters 5a and 5b at a time of energization can be moderately increased. The temperature of the heaters 5a and 5b at a time of energization can be made higher than the temperature of the electron source 1 by, for example, approximately 150 to 250°C. As a result, it is possible to suppress deposition of the material configuring the electron source 1 in the vicinity of the heaters 5a and 5b.

### (Intermediate Member)

The intermediate members 2a and 2b are disposed so as to be in contact with and cover a pair of surfaces 1b and 1c of the electron source 1 (see FIG. 1B). The intermediate members 2a and 2b are exposed to each of the side surfaces 10a and 10b of the emitter 10. The length of the shortest path of the intermediate member passing from the heater to the electron source is 100 µm or more. In other words, in the present embodiment, the thickness of the intermediate member 2a (separation distance between the electron source 1 and the heater 5a) is preferably 100 µm or more, and the thickness may be 100 to 1000 µm or 300 to 800 µm.

The intermediate members 2a and 2b are made of a material (second material) lower in thermal conductivity than the material configuring the electron source 1. The thermal conductivity of the material configuring the intermediate members 2a and 2b is, for example, 100 W/m·K or less, preferably 1 to 100 W/m·K and more preferably 1 to 60 W/m·K. The lower limit value of this value may be 2 W/m·K or 3 W/m·K. The upper limit value of this value may be 45 W/m·K or 40 W/m·K. By the thermal conductivity of this material being 1 W/m·K or more, heat from the heaters 5a and 5b tends to be sufficiently transmitted to the electron source 1. On the other hand, by the thermal conductivity of this material being 100 W/m·K or less, there is a tendency that a sufficient temperature difference can be caused between the heaters 5a and 5b and the electron source 1.

The material configuring the intermediate members 2a and 2b contains glassy carbon. Glassy carbon (such as Glassy Carbon (product name, manufactured by Reiho Manufacturing Co., Ltd.)) may be used as this material. The thermal conductivities of a plurality of materials are as follows.
·Metal rhenium: 48 W/m·K
·Boron carbide: 35 W/m·K
·Graphite: 80 to 250 W/m·K
·Glassy carbon: 5.8 W/m·K

The material configuring the intermediate members 2a and 2b is electrically conductive. From the viewpoint of suppressing excessive heat generation of the intermediate members 2a and 2b attributable to energization, it is preferable that the material configuring the intermediate members 2a and 2b is lower in electrical resistivity than the material configuring the heaters 5a and 5b. The electrical resistivity of the material configuring the intermediate members 2a and 2b is preferably 300 µΩ·m or less, more preferably 100 µΩ·m or less. By the electrical resistivity of this material being 300 µΩ·m or less, excessive heat generation of the intermediate members 2a and 2b attributable to energization tends to be suppressible. It should be noted that the lower limit value of the electrical resistivity of this material is, for example, 0.1 µΩ·m, and the value may be 0.3 µΩ·m or 1.0 µΩ·m. The electrical resistivities of a plurality of materials are as follows.
·Metal rhenium: 0.2 µΩ·m
·Graphite: 5 to 15 µΩ·m
·Glassy carbon: 42 µΩ·m

### (Heater)

The heaters 5a and 5b are made of a high-electrical resistivity material and generate heat by energization. The electrical resistivity of the material configuring the heaters 5a and 5b is preferably 500 to 1000 µΩ·m, more preferably 600 to 900 µΩ·m. By the electrical resistivity of this material being 500 µΩ·m or more, the electron source 1 tends to be sufficiently heatable by energization. On the other hand, by the electrical resistivity of this material being 1000 µΩ·m or less, sufficient energization tends to be possible. Examples of the material configuring the heaters 5a and 5b include pyrolytic graphite and hot-pressed carbon. It should be noted that the electrical resistivity (typical value) of pyrolytic graphite is 800 µΩ·m.

An electrical resistivity value R_{H} of the heaters 5a and 5b is preferably sufficiently larger than an electrical resistivity value R_{I} of the intermediate members 2a and 2b. The ratio (R_{H}/R_{I}) of the electrical resistivity value R_{H} of the heaters 5a and 5b to the electrical resistivity value R_{I} of the intermediate members 2a and 2b is, for example, 12 to 20, and the ratio may be 13 to 19 or 14 to 18. By this ratio being 12 or more, the temperature of the heaters 5a and 5b at a time of energization can be sufficiently increased, and deposition of the material configuring the electron source 1 in the vicinity of the heaters 5a and 5b tends to be suppressible. On the other hand, by this ratio being 20 or less, there is a tendency that the loss of electric power for heating the heaters 5a and 5b can be reduced.

### <Second Embodiment>

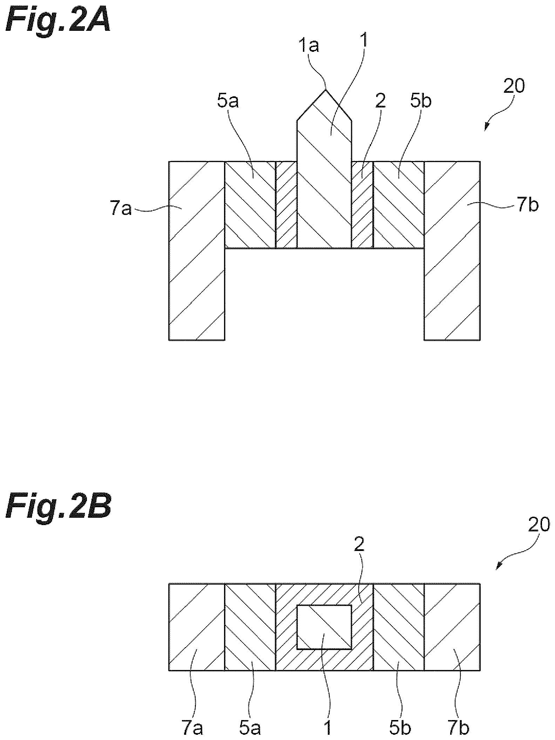

FIG. 2A is a longitudinal sectional view schematically illustrating an emitter according to a second embodiment, and FIG. 2B is a transverse sectional view of the emitter illustrated in FIG. 2A. An emitter 20 illustrated in these drawings differs from the emitter 10 according to the first embodiment in that the four side surfaces of the columnar portion of the electron source 1 are covered with an intermediate member 2. In other words, the intermediate member 2 is interposed between the electron source 1 and the heaters 5a and 5b in the present embodiment whereas the intermediate member 2a is interposed between the electron source 1 and the heater 5a and the intermediate member 2b is interposed between the electron source 1 and the heater 5b in the first embodiment. By the four side surfaces of the columnar portion of the electron source 1 being covered with the intermediate member 2, it is possible to, for example, suppress the diffusion of evaporated matter from the electron source and uniformly heat the electron source. It should be noted that the material of the intermediate member 2 may be the same as the material of the intermediate members 2a and 2b according to the first embodiment.

### <Third Embodiment>

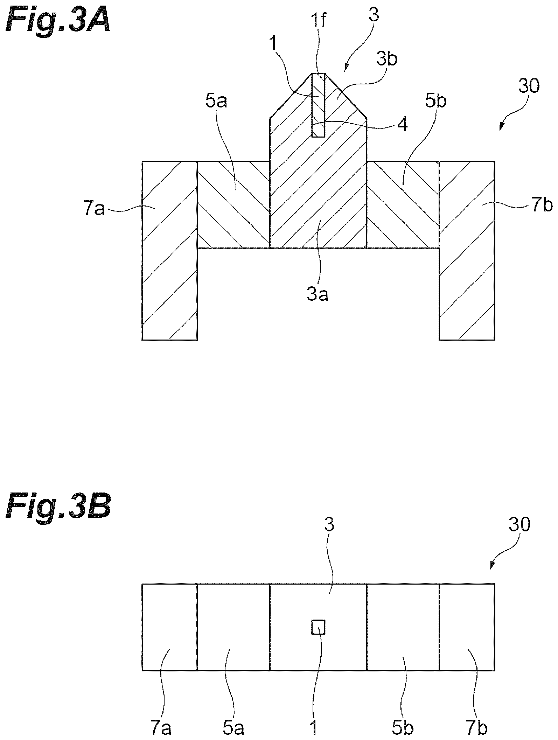

FIG. 3A is a longitudinal sectional view schematically illustrating an emitter according to a third embodiment, and FIG. 3B is a transverse sectional view of the emitter illustrated in FIG. 3A. In an emitter 30 illustrated in these drawings, an intermediate member 3 comprises a columnar portion 3a and a conical part 3b. An opening portion 4 is provided in the tip portion of the conical part 3b, and the electron source 1 is inserted in the opening portion 4. The surface of the tip of the electron source 1 is an electron emission surface 1f. It should be noted that the material of the intermediate member 3 may be the same as the material of the intermediate members 2a and 2b according to the first embodiment.

In the present embodiment, the electron source 1 has a quadrangular prism shape (see FIGS. 3A and 3B). The length of the electron source 1 is, for example, 0.1 to 1 mm, and the length may be 0.2 to 0.6 mm or 0.3 mm. By the length being 0.1 mm or more, handling tends to be satisfactory. By the length being 1 mm or less, cracking or the like tends to be less likely to occur. The electron source 1 has a substantially square sectional shape. The length of the side is, for example, 20 to 300 µm, and the length may be 50 to 150 µm or 100 µm.

In the present embodiment, the columnar portion 3a of the intermediate member 3 has a quadrangular prism shape (see FIGS. 3A and 3B). The columnar portion 3a has a substantially square sectional shape. The length of the side is, for example, 0.5 to 2 mm, and the length may be 0.6 to 1 mm or 0.7 to 0.9 mm.

By the surface of the electron source 1 other than the electron emission surface being covered with the intermediate member 3, electron emission from the surface other than the electron emission surface is suppressed. Although the tip of the electron source 1 may or may not protrude from the tip of the conical part 3b of the intermediate member 3, it is preferable that the tip of the electron source 1 does not protrude from the tip of the conical part 3b of the intermediate member 3. By the tip of the electron source 1 not protruding from the intermediate member 3, unnecessary electron emission, that is, lateral electron emission can be sufficiently suppressed. For example, in order to obtain electrons of a larger current, the tip portion of the electron source 1 is heated to a high temperature of approximately 1550°C and a high electric field of several kV is applied to the electron source 1. When such a high electric field is applied, surplus electrons can be generated from the non-tip part of the electron source as well. Due to the space charge effect, this surplus electron may reduce the brightness of an electron beam from the tip part or cause unnecessary heating of a surrounding electrode component. In order to prevent this, only the surface of the tip of the electron source 1 is exposed, the other surface is covered with the intermediate member 3, and only a high-brightness electron beam can be obtained from the tip part. It should be noted that the tip of the electron source 1 may be recessed with respect to the tip of the conical part 3b of the intermediate member 3.

By covering the entire side surface of the electron source 1 with the intermediate member 3, there is also the effect of being capable of suppressing the occurrence of a phenomenon called microdischarge. In other words, in thermionic emission, electrons are emitted by heating an electron source to a high temperature. The resultant electron emission material evaporation results in adhesion to a surrounding electrode component and fibrous crystals called whiskers. Microdischarge results from charge accumulation in this whisker to result in electron beam destabilization and device performance decline. By covering the entire side surface of the electron source 1 with the intermediate member 3, the sublimated electron emission material is trapped in the intermediate member 3, the amount of adhesion to a surrounding electrode component can be reduced, and microdischarge can be made unlikely to occur. It should be noted that the intermediate member 3 covers the entire side surface of the electron source 1 without having a cut at a circumferential part. Since the intermediate member 3 is cut-less, lateral electron emission can be sufficiently suppressed.

The present invention is not limited to the embodiments of the present disclosure described in detail above. For example, although the electron source exemplified in the above embodiments has a columnar portion with a substantially square sectional shape, the sectional shape of the columnar portion may be substantially polygonal instead of being substantially square. For example, the shape may be substantially rectangular, substantially rhombic, substantially parallelogrammic, substantially triangular (for example, substantially equilateral-triangular), or substantially regular-hexagonal. The sectional shape of the opening portion 4 in the third embodiment may not match the sectional shape of the electron source. For example, the shape may be substantially circular, substantially rhombic, substantially parallelogrammic, substantially triangular (for example, substantially equilateral-triangular), or substantially regular-hexagonal.

### Examples

Hereinafter, the present disclosure will be described based on an example and a comparative example. It should be noted that the present invention is not limited to the following examples.

### (Example)

Using the materials shown in Table 1, an emitter having the same configuration as the emitter illustrated in FIG. 1 was produced. The length of the electron source was approximately 0.3 mm, and the length of one side of the columnar portion was approximately 100 µm. The thickness of the intermediate member (separation distance between the electron source and the heater) was set to 300 µm.

**[Table 1]**

| | Electron source | Intermediate member | Heater |
|---|---|---|---|
| Material | Lanthanum boride (LaB₆) | Glassy carbon | Pyrolytic graphite |
| Thermal conductivity [W/m·K] | 60 | 5.8 | 5 to 10 |
| Electrical resistivity [µΩ·m] | 0.08 | 42 | 791 |

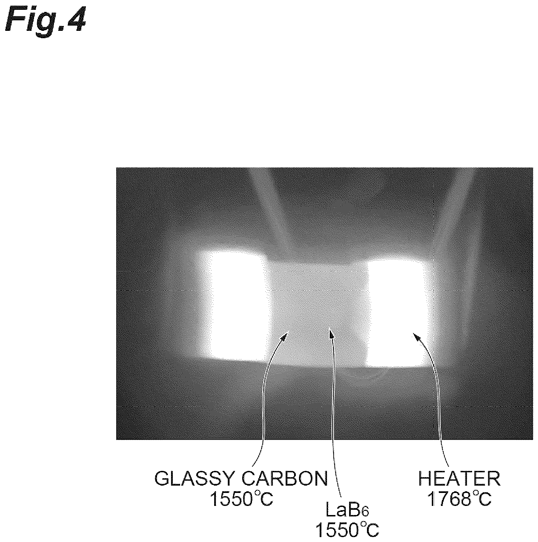

The temperature of the heater was 1768°C when the emitter was energized under constant current control such that the temperature of the electron source was 1550°C. FIG. 4 is a thermographic camera image showing the upper surface temperature of the emitter according to the example. According to the present inventors' examinations, it is preferable from the viewpoint of lanthanum boride deposition prevention that the temperature of the heater is 1700 to 1800°C when the electron source is heated to 1550°C.

### (Comparative Example)

An emitter identical in configuration to the example except that no intermediate member was disposed between the electron source and the heater was produced (see FIG. 5A). The temperature of the heater was 1634°C when the emitter was energized under constant current control such that the temperature of the electron source was 1550°C.

### Industrial Applicability

Provided according to the present disclosure are an emitter capable of maintaining high reliability even during long-term operation and a device provided with the same.

### Reference Signs List

1: electron source, 1f: electron emission surface, 2, 2a, 2b, 3: intermediate member, 5a, 5b: heater, 10, 20, 30: emitter.

## Claims

1. An emitter (10, 20, 30) comprising:
first and second heaters (5a, 5b) generating heat by energization;
an electron source (1) comprising a first material emitting an electron by being heated by the first and second heaters (5a, 5b); and
an intermediate member (2, 2a, 2b, 3) interposed between the electron source, and the first and second heaters (5a, 5b), the intermediate member (2, 2a, 2b, 3) comprising a second material lower in thermal conductivity than the first material,
wherein the first material is a rare earth boride or a precious metal-rare earth alloy, and the second material is glassy carbon, and
wherein a length of a shortest path of the intermediate member (2, 2a, 2b, 3) passing from the heater (5a, 5b) to the electron source (1) is 100 µm or more.

2. The emitter (10, 20, 30) according to claim 1, wherein
an electrical resistivity value of the intermediate member (2, 2a, 2b, 3) is 300 µΩ·m or less, and
an electrical resistivity value of the heater (5a, 5b) is 500 µΩ·m or more.

3. The emitter (10, 20, 30) according to claim 1or 2, wherein the first material is a rare earth boride.

4. The emitter (10, 20, 30) according to claim 3, wherein the first material is a lanthanum boride or a cerium boride.

5. The emitter (10, 20, 30) according to claim 1 or 2, wherein the first material is a precious metal-rare earth alloy.

6. The emitter (10, 20, 30) according to claim 5, wherein the first material is an iridium cerium.

7. The emitter according to any one of claims 1 to 6, wherein the intermediate member (3) covers a surface of the electron source (1) other than an electron emission surface (1f).

8. A device (10, 20, 30) comprising the emitter according to any one of claims 1 to 7.

## Patentansprüche

1. Emitter (10, 20, 30), umfassend:
erste und zweite Heizvorrichtungen (5a, 5b), die durch Erregung Wärme erzeugen;
eine Elektronenquelle (1), die ein erstes Material umfasst, das ein Elektron emittiert, indem es von den ersten und zweiten Heizvorrichtungen (5a, 5b) erwärmt wird; und
ein Zwischenelement (2, 2a, 2b, 3), das zwischen der Elektronenquelle und den ersten und zweiten Heizvorrichtungen (5a, 5b) angeordnet ist, wobei das Zwischenelement (2, 2a, 2b, 3) ein zweites Material mit einer geringeren Wärmeleitfähigkeit als das erste Material umfasst,
wobei das erste Material ein Seltenerd-Borid oder eine Edelmetall-Seltenerd-Legierung ist und das zweite Material glasartiger Kohlenstoff ist, und
wobei eine Länge eines kürzesten Weges des Zwischenelements (2, 2a, 2b, 3), der von der Heizvorrichtung (5a, 5b) zu der Elektronenquelle (1) führt, 100 µm oder mehr beträgt.

2. Emitter (10, 20, 30) nach Anspruch 1, wobei
ein elektrischer Widerstandswert des Zwischenelements (2, 2a, 2b, 3) 300 µΩ·m oder weniger beträgt, und
ein elektrischer Widerstandswert der Heizvorrichtung (5a, 5b) 500 µΩ·m oder mehr beträgt.

3. Emitter (10, 20, 30) nach Anspruch 1 oder 2, wobei das erste Material ein Seltenerd-Borid ist.

4. Emitter (10, 20, 30) nach Anspruch 3, wobei das erste Material ein Lanthanborid oder ein Ceriumborid ist.

5. Emitter (10, 20, 30) nach Anspruch 1 oder 2, wobei das erste Material eine Edelmetall-Seltenerd-Legierung ist.

6. Emitter (10, 20, 30) nach Anspruch 5, wobei das erste Material ein Iridium-Cerium ist.

7. Emitter nach einem der Ansprüche 1 bis 6, wobei das Zwischenelement (3) eine andere Oberfläche der Elektronenquelle (1) als eine Elektronenemissionsoberfläche (1f) bedeckt.

8. Vorrichtung (10, 20, 30), die den Emitter nach einem der Ansprüche 1 bis 7 umfasst.

## Revendications

1. Émetteur (10, 20, 30) comprenant :
des premier et second moyens de chauffage (5a, 5b) générant de la chaleur par excitation ;
une source d'électrons (1) comprenant un premier matériau émettant un électron en étant chauffé par les premier et second moyens de chauffage (5a, 5b) ; et
un élément intermédiaire (2, 2a, 2b, 3) interposé entre la source d'électrons et les premier et second moyens de chauffage (5a, 5b), l'élément intermédiaire (2, 2a, 2b, 3) comprenant un second matériau de conductivité thermique inférieure au premier matériau,
dans lequel le premier matériau est un borure de terre rare ou un alliage de métaux précieux-terres rares, et le second matériau est du carbone vitreux, et
dans lequel une longueur d'un chemin le plus court de l'élément intermédiaire (2, 2a, 2b, 3) passant à travers le moyen de chauffage (5 a, 5b) jusqu'à la source d'électrons (1) est supérieure ou égale à 100 µm.

2. Émetteur (10, 20, 30) selon la revendication 1, dans lequel
une valeur de résistivité électrique de l'élément intermédiaire (2, 2a, 2b, 3) est inférieure ou égale à 300 µΩ·m, et
une valeur de résistivité électrique du moyen de chauffage (5a, 5b) est supérieure ou égale à 500 µΩ·m.

3. Émetteur (10, 20, 30) selon la revendication 1 ou 2, dans lequel le premier matériau est un borure de terre rare.

4. Émetteur (10, 20, 30) selon la revendication 3, dans lequel le premier matériau est un borure de lanthane ou un borure de cérium.

5. Émetteur (10, 20, 30) selon la revendication 1 ou 2, dans lequel le premier matériau est un alliage de métaux précieux-terres rares.

6. Émetteur (10, 20, 30) selon la revendication 5, dans lequel le premier matériau est un cérium iridium.

7. Émetteur selon l'une quelconque des revendications 1 à 6, dans lequel l'élément intermédiaire (3) couvre une surface de la source d'électrons (1) différente d'une surface d'émission d'électrons (1f).

8. Dispositif (10, 20, 30) comprenant l'émetteur selon l'une quelconque des revendications 1 à 7.
